# EUROPEAN PATENT APPLICATION

(11) **EP 4 235 696 A1**
(43) Date of publication of application: **30.08.2023**
(21) Application number: 21883152.7
(22) Date of filing: 18.10.2021
(51) Int. Cl.: G21D 1/00, G06T 19/20, G06T 19/00, G06Q 50/10

(54) **CONSTRUCTION SIMULATION SYSTEM AND METHOD FOR NUCLEAR POWER PLANT EQUIPMENT**

(30) Priority: 20.10.2020 KR 20200136294
(71) Applicant: Korea Hydro & Nuclear Power Co., Ltd, Gyeongju-si, Gyeongsangbuk-do 38120 (KR)
(72) Inventor: LIM, Byung Ki, Daejeon 34101 (KR)
(74) Representative: Habermann, Hruschka & Schnabel
(86) International application number: PCT/KR2021/014465
(87) International publication number: WO 2022/086081

(57) **Abstract**

The objective of the present invention is to provide a construction simulation system for nuclear power plant equipment, the system comprising: an information input unit into which nuclear power plant equipment installation information related to nuclear power plant equipment is inputted; a simulation implementation unit for generating a virtual reality simulation related to the nuclear power plant equipment on the basis of the nuclear power plant equipment installation information, and allowing the virtual reality simulation to be outputted through a nuclear power plant equipment installation simulation program; and a utilization unit for outputting the virtual reality simulation.

## Description

### Technical Field

The present invention relates to a construction simulation system and method for nuclear power plant equipment, and more particularly, to a construction simulation system and method for nuclear power plant equipment using virtual reality technologies.

### Background Art

Virtual reality technologies are technologies that express a real environment as a three-dimensional virtual environment, and are applied to various industrial fields. In particular, in equipment, such as plant equipment, where products such as oil, electric power, and gas, are produced, the virtual reality technologies are applied to improve work efficiency of an operator.

A plant technology to which such virtual reality technologies are applied has already been disclosed by "Korean Patent Application Publication No. 2018-0069539 (METHOD FOR PROVIDING VIRTUAL REALITY SERVICE OF PLANT AND DEVICE FOR THE SAME, June 25, 2018)". The disclosed invention visualizes the inside and outside of a plant through a virtual reality technology and delivers the visualized inside and outside to an operator.

However, due to the high level of difficulty in the process of installing the main equipment of a nuclear power plant, including a reactor, and the high level of difficulty in the series of tasks involved in assembly, installation, inspection, and documentation, there are persistent demands for a system that utilizes a virtual reality technology.

### Disclosure

### Technical problem

An object of the present invention is to provide a construction simulation system and method for nuclear power plant equipment, by which all shape information, installation methods, information expressions of construction procedure documents for a reactor required for installation of nuclear power plant equipment are visualized in a virtual space so that an operator can utilize the visualized information.

In addition, another object of the present invention is to provide a construction simulation system and method for nuclear power plant equipment, by which visualized screens and related information are provided to a user through a simulation without an operator's separately searching for separate information required in procedure documents or backbone systems.

### Technical Solution

A construction simulation system for nuclear power plant equipment according to the present invention includes: an information input unit into which nuclear power plant installation information related to nuclear power plant equipment is input; a simulation implementation unit configured to generate a virtual reality simulation related to the nuclear power plant equipment on the basis of the nuclear power plant equipment installation information, and allow the virtual reality simulation to be output through a nuclear power plant equipment installation simulation program; and a utilization unit configured to output the virtual reality simulation.

The nuclear power plant equipment installation information includes at least one of a three-dimensional (3D) model, a scenario, general information, an experience image, a video, a checklist, and other information of the nuclear power plant equipment; the 3D model of the nuclear power plant equipment includes design information; the scenario includes a scenario generated on the basis of experience data and related procedures experienced by an operator in installation of existing nuclear power plant equipment,; general information includes reference information having at least one of term definitions and safety guidelines, the experience image includes data taken when the operator installed the existing nuclear power plant equipment; the video includes a video related to nuclear power plant equipment of a preceding power plant; the checklist includes inspection items to inspect at a time of installing the nuclear power plant equipment; and the other information includes two-dimensional (2D) drawings.

The construction simulation system for nuclear power plant equipment further includes an information storage unit configured to store the nuclear power plant equipment installation information, and the information storage unit includes: a 3D storage unit configured to store 3D model information; a scenario storage unit configured to store scenario information that refers to installation experience data of the nuclear power plant equipment and the WPP/QCI procedure documents; and a related information storage unit configured to store at least one of term definitions, general matters, attachments, and corresponding procedures required for construction of the nuclear power plant equipment.

The nuclear power plant equipment installation simulation program includes: a first screen for selecting the nuclear power plant equipment to be constructed; a second screen outputting information on the construction of the nuclear power plant equipment; a third screen outputting information on construction activity information of the nuclear power plant equipment and allowing an operator to select a simulation; and a fourth screen outputting a simulation for the construction of the nuclear power plant equipment.

The first screen outputs an image of the nuclear power plant equipment so as to enable selection of the nuclear power plant equipment.

The second screen includes: a term definition outputting button for outputting information on term definitions, safety guidelines, and general matters for the nuclear power plant equipment; a safety guideline outputting button for outputting information to be used in activities of the construction of the nuclear power plant equipment, check items, and caution-required items; a safety guideline outputting button for outputting information on reference forms and relevant documents related to the construction of the nuclear power plant equipment; and a drawing outputting button for outputting information on 2D drawings and 3D models related to activities of the construction of the nuclear power plant equipment.

The third screen may include a construction simulation activity button for selecting a necessary simulation from among a plurality of simulations for the nuclear power plant equipment.

The fourth screen outputs a simulation image for the construction of the nuclear power plant equipment and includes: a common information outputting button for outputting the term definitions, safety guidelines, and general matters necessary for the construction of the nuclear power plant equipment; an information outputting button for outputting basic information, check items, and caution-required items necessary for the construction of the nuclear power plant equipment; a document outputting button for outputting reference forms and relevant documents necessary for the construction of the nuclear power plant equipment; a drawing outputting button for outputting drawings necessary for the construction of the nuclear power plant equipment; an experience image outputting button for outputting a photograph at a time of prior construction of the nuclear power plant equipment; and an inspection item check button for outputting inspection items related to the construction of the nuclear power plant equipment.

The utilization unit may be capable of operating the nuclear power plant installation simulation program.

Meanwhile, a construction simulation method for nuclear power plant equipment according to the present invention includes: entering nuclear power plant equipment installation information related to nuclear power plant equipment; generating a virtual reality simulation related to the nuclear power plant equipment on the basis of the nuclear power plant equipment installation information and outputting the virtual reality simulation through a nuclear power plant equipment installation simulation program; and outputting the virtual reality simulation by the utilization unit.

### Advantageous Effects

A construction simulation system and method for nuclear power plant equipment according to the present invention can improve work efficiency by establishing the same environment as the real world based on 3D shapes and a virtual reality technology, rather than using conventional document-based procedures, for installation of nuclear power plant equipment.

In addition, the construction simulation system and method for nuclear power plant equipment according to the present invention may can enhance an operator's understanding of a method for installing nuclear power plant equipment through a simulation in a virtual space before construction, improve workability and safety, and allow acquisition of systematic know-hows by linking related information.

In addition, the construction simulation system and method for nuclear power plant equipment according to the present invention can reduce a user's time to search for information by verifying safety guidelines, key term definitions, inspection items to inspect before construction, and previous experience data in a simulation in a virtual space.

The technical effects of the present invention as described above are not limited to the effects mentioned above, and other technical effects not mentioned will be clearly understood by those skilled in the art from the description below.

### Description of Drawings

FIG. 1 is a schematic configuration diagram of a construction simulation system for nuclear power plant equipment according to this embodiment;
FIG. 2 is a configuration diagram schematically illustrating an information input unit of a construction simulation system for nuclear power plant equipment according to this embodiment;
FIG. 3 is a configuration diagram schematically illustrating the information storage unit of the construction simulation system for nuclear power plant equipment according to this embodiment,
FIG. 4 is a configuration diagram schematically illustrating a simulation implementation unit of a construction simulation system for nuclear power plant equipment according to this embodiment;
FIG. 5 is a conceptual diagram illustrating an initial screen and an information screen in a nuclear reactor installation program according to this embodiment;
FIG. 6 is a configuration diagram illustrating a construction activity selection screen in a nuclear reactor installation program according to this embodiment; and
FIG. 7 is a block diagram illustrating an output of a nuclear reactor installation simulation in a reactor installation program according to this embodiment.

### Mode for Disclosure

Hereinafter, embodiments of the present invention will be described in detail with reference to the accompanying drawings. The embodiments of the present invention, however, may be changed into several other forms, and the scope of the present invention should not be construed as being limited to the following embodiments, and the embodiments of the present invention are intended to more comprehensively explain the present invention to those skilled in the art. The shapes of elements or the like shown in drawings are exaggerated to emphasize distinct explanation, and elements indicated by like reference numerals in the figures mean like elements.

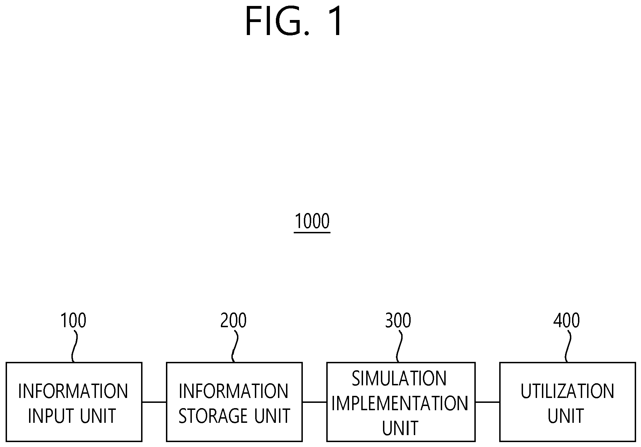

FIG. 1 is a schematic configuration diagram of a construction simulation system for nuclear power plant equipment according to this embodiment.

As shown in FIG. 1, a construction simulation system 1000 for nuclear power plant equipment according to this embodiment includes an information input unit 100, an information storage unit 200, a simulation implementation unit 300, and a utilization unit 400.

First, nuclear power plant installation information such as a three-dimensional (3D) model and a simulation scenario for each construction unit related to nuclear reactor installation may be input by a user to the information input unit 100. In addition, the nuclear power plant installation information may be stored in the information storage unit 200, and the nuclear power plant installation information may be updated as needed.

Further, the simulation implementation unit 300 generates a simulation which visualizes the nuclear reactor installation based on the nuclear power plant installation information, and the utilization unit 400 outputs a reactor installation simulation program P 100 including the generated simulation. Accordingly, the operator may utilize the related simulation through the utilization unit 400, and may be able to operate the nuclear reactor installation simulation program P100.

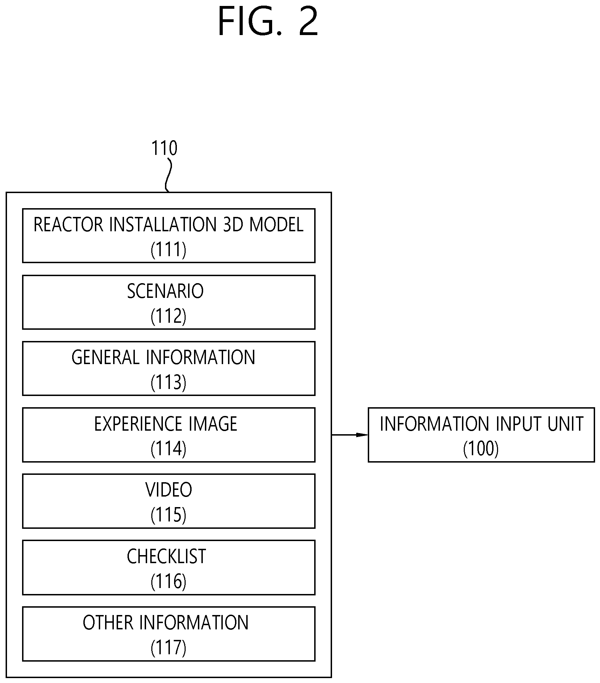

FIG. 2 is a configuration diagram schematically illustrating an information input unit of a construction simulation system for nuclear power plant equipment according to this embodiment.

As shown in FIG. 2, the nuclear power plant installation information 110 is input by an operator into the information input unit 100 according to this embodiment. For example, the nuclear power plant installation information 110 includes a reactor installation 3D model 111, a scenario 112, general information 113, an experience image 114, a video 115, a checklist 116, and other information 117.

The nuclear reactor installation 3D model 110 may be a 3D installation model that represents design information related to nuclear reactor installation, such as a lower support and a nuclear reactor which constitute the nuclear reactor. Further, the scenario 112 may be a scenario generated according to experience data and related procedures experienced by a previous operator in nuclear reactor installation. The general information 113 may be reference information corresponding to the corresponding installation, such as term definitions and safety guidelines. In addition, the experience image 114 may be an image representing previous experience data taken in a previous operator's nuclear reactor installation. The video 115 may be a video related to installation of a nuclear reactor of a preceding power plant, and the checklist 116 may be a checklist of a corresponding activity, such as a checklist for the upper position of a reactor column support, that is, checklist information indicating inspection items to inspect at a time of installing a nuclear reactor. Further, the other information 117 may be additional information such as a two-dimensional (2D) drawing. However, this is merely for explaining this embodiment, and the type of nuclear power plant installation information may change as needed.

Meanwhile, the information storage unit 200 may store the nuclear power plant installation information 110, so that the nuclear power plant installation information can be edited and updated as needed.

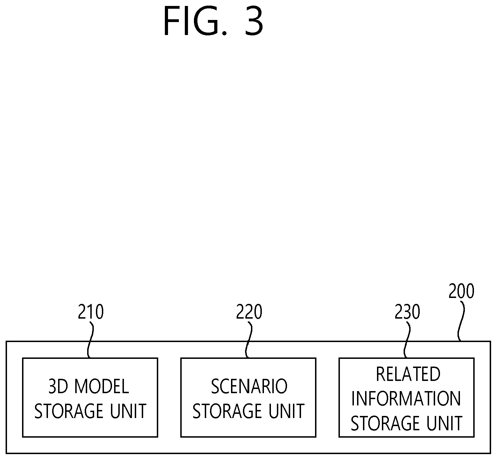

FIG. 3 is a configuration diagram schematically illustrating an information storage unit of a construction simulation system for nuclear power plant equipment according to this embodiment.

As shown in FIG. 3, the information storage unit 200 according to this embodiment may include a 3D model storage unit 210, a scenario storage unit 220, and a related information storage unit 230.

First, 3D model information input through the information input unit is stored in the 3D model storage unit 210. At this point, 3D model information such as an anchor bolt, a lower support, a nuclear reactor, and a crane may be input and stored in the 3D model storage unit 210. The scenario storage unit 220 may store scenario information referring to nuclear reactor installation experience data and WPP/QCI procedure documents through the government input unit 100, and the related information storage unit 230 stores term definitions, general information, attachments, related information about corresponding procedures, and the like.

Accordingly, the simulation implementation unit 300 may generate a simulation for nuclear power plant installation based on the nuclear power plant installation information 110 so that the generated simulation is output through the utilization unit 400.

Hereinafter, the nuclear reactor installation simulation program P100 generated and implemented through the simulation implementation unit 300 will be described in detail with reference to the accompanying drawings.

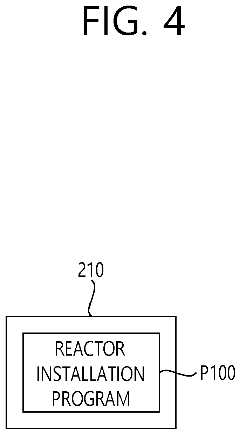

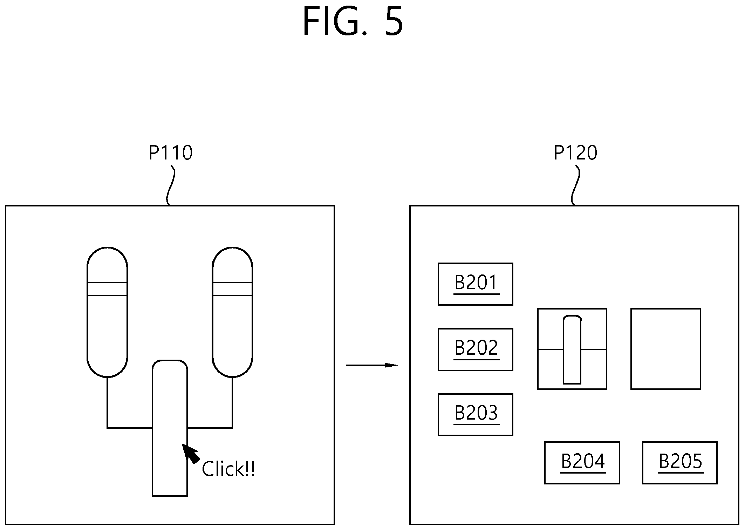

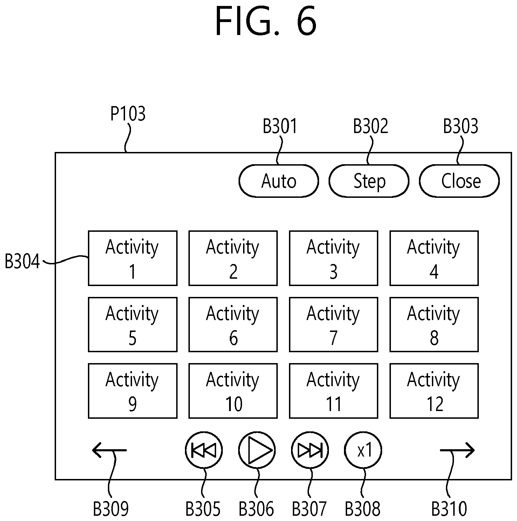

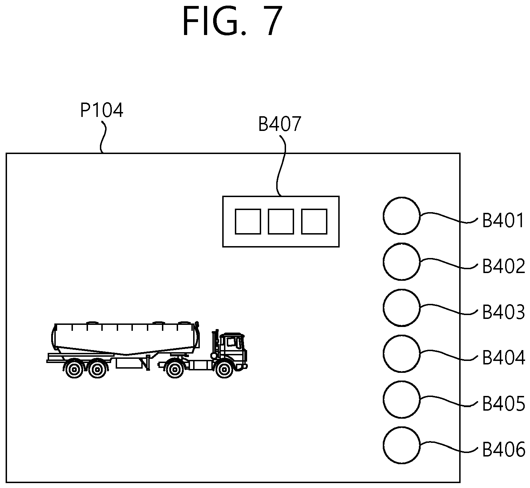

FIG. 4 is a schematic configuration diagram illustrating a simulation implementation unit of a construction simulation system for nuclear power plant equipment according to this embodiment, and FIG. 5 is a conceptual diagram illustrating an initial screen and an information screen in a nuclear reactor installation program according to this embodiment. In addition, FIG. 6 is a configuration diagram illustrating a construction activity selection screen in a reactor installation program according to this embodiment, and FIG. 7 is a configuration diagram illustrating output of a nuclear reactor installation simulation in a reactor installation program according to this embodiment.

As shown in FIGS. 4 to 7, the simulation implementation unit 300 according to this embodiment generates a simulation based on the nuclear power plant installation information 110 so that the simulation is output through the nuclear reactor installation simulation program P100. Here, the reactor installation simulation program P100 outputs the simulation through the utilization unit 400 so that an operator can view and experience the simulation. Here, the utilization unit 400 may include a computer/monitor and a virtual reality (VR) device.

Hereinafter, an example of the nuclear reactor installation simulation program P100 will be described in detail with reference to the accompanying drawings.

First, in the reactor installation simulation program P100, an initial screen P110 is output. In the initial screen P110, an image of a nuclear reactor is output so that a reactor to be constructed may be selected. At this point, when the operator selects an image of the corresponding nuclear reactor to be constructed, an information screen P120 for the corresponding nuclear reactor may be output.

Here, a term definition outputting button B201, a safety guideline outputting button B202, a general information outputting button B203, a drawing outputting button B204, and a simulation outputting button B205 may be output on the information screen P120 so that information on construction can be output.

The term definition outputting button B201 outputs a list of term definitions, safety guidelines, and general matters for the reactor to be constructed according to the operator's selection, and allows the operator to check the corresponding contents according to the operator's selection. In addition, the safety guideline outputting button B202 may output information, check items, and caution-required items, which are to be used by the operator in activities of the construction according to the operator's selection. In addition, the general information outputting button B203 for checking reference forms and relevant documents related to the activities of the construction according to the operator's selection. The drawing outputting button B204 enables confirmation of 2D drawings and 3D models related to the corresponding construction activities, and enables confirmation of specifications for the drawings and models when checking the 2D drawings and 3D models.

Meanwhile, when the operator selects the simulation outputting button B205, the information screen P120 is switched in the reactor installation simulation program P100 and the construction activity selection screen P130 is output.

On the construction activity selection screen P130, an automatic/manual selection button B301, a step selection button B302, an end button B303, a construction simulation activity button B304, a preceding activity switch button B305, a play/pause selection button B306, a subsequent activity switch button B307, a speed control button B308, a preceding list switch button B309, and a subsequent list switch button B310 may be output, so that activity information on the construction can be checked.

The automatic/manual selection button B301 enables a selection to automatically or manually proceed with a simulation process generated and output from the reactor installation simulation program P100. That is, the operator may be able to automatically or manually proceed with a subsequent simulation through the automatic/manual selection button B301.

The step selection button B302 enables a selection to automatically or manually proceed with a simulation for each activity related to installation of a corresponding nuclear reactor. That is, through the step selection button B302, the operator may have a simulation of an activity selected later automatically or manually proceed with.

In addition, the end button B303 causes the simulation to end when selected by the operator, and causes the reactor installation simulation program P100 to return to the initial screen P 110.

A plurality of construction simulation activity buttons B304 may be provided to correspond to corresponding nuclear reactor installation activities. For example, the construction simulation activity buttons B304 may be provided in plural so as to individually check a series of processes such as reactor assembly, installation, inspection, and document inspection. Accordingly, the plurality of construction simulation activity buttons B304 outputs a simulation of a selected procedure according to the operator's selection. However, in this embodiment, although assembly, installation, inspection, and document inspection are separately described in the construction procedure, this is merely for explaining this embodiment, and the construction procedure may be further subdivided.

Further, the subsequent activity switch button B307 enables switching to a simulation indicating a subsequent activity. That is, the subsequent activity switch button B307 causes a simulation of a procedure subsequent to the corresponding procedure to be output.

The play/pause selection button B306 enables a simulation to be paused and continued according to the operator's selection.

Further, the preceding activity switch button B305 enables switching to a simulation representing a preceding activity. That is, the preceding activity switch button B305 enables return to the simulation of a procedure prior to the corresponding procedure.

The speed control button B308 enables the operator to adjust a simulation progress speed, and for example, the simulation progress speed may be selected from 1 to 4 times.

Further, the preceding list switch button B309 outputs a simulation list indicating preceding activities prior to the corresponding procedure, and the subsequent list switch button B310 outputs a simulation list representing subsequent activities following the corresponding procedure.

Meanwhile, when a user selects the construction simulation activity button or the reactor installation program needs to output a simulation as needed, the construction activity selection screen P130 is switched and the reactor installation simulation P140 is output.

In the reactor installation simulation P140, a construction image for the construction of the reactor is output, and a common information outputting button B401, an information outputting button B402, a document outputting button B403, a drawing outputting button B404, an experience image outputting button B405, an inspection item check button B406, and a sub-menu outputting button B407 may be output together.

First, the common information outputting button B401 outputs a list of term definitions, safety guidelines, and general matters required for construction of a nuclear reactor, and enables confirmation of the contents. In addition, the information outputting button B402 enables outputting basic information, check items, and caution-required items for the corresponding construction activity, and the document outputting button B403 enables confirmation of reference forms and relevant documents related to the corresponding nuclear reactor construction activity, if necessary. The drawing outputting button B404 enables outputting of the construction drawing, the experience image outputting button B405 enables confirmation of a picture of the preceding construction related to the corresponding construction activity, and the inspection item check button B406 for checking inspection items related to the corresponding construction activity. In the sub-menu output window B407, information, information, documents, drawings, experience images, videos, and the like corresponding to the corresponding activity, such as term definitions, safety guidelines, and general matters, may be output according to the user's selection.

As such, the construction simulation system for nuclear power plant equipment according to the present invention can improve work efficiency by establishing the same environment as the real world based on 3D shapes and a virtual reality technology, rather than using conventional document-based procedures, for installation of nuclear power plant equipment.

In addition, the construction simulation system for nuclear power plant equipment according to the present invention may can enhance an operator's understanding of a method for installing nuclear power plant equipment through simulation in a virtual space before construction, improve workability and safety, and allow acquisition of systematic know-hows by linking related information.

In addition, the construction simulation system for nuclear power plant equipment according to the present invention can reduce a user's time to search for information by verifying safety guidelines, key term definitions, inspection items to inspect before construction, and previous experience data in a simulation in a virtual space.

The embodiments of the present invention described above and shown in the drawings should not be construed as limiting the technical spirit of the present invention. The scope of the present invention is restricted by only the claims, and a person having ordinary skill in the art to which the present invention pertains may improve and modify the technical spirit of the present invention in various forms. Accordingly, such modifications and changes will fall within the scope of the present invention as long as they are evident to those skilled in the art.

## Claims

1. A construction simulation system for nuclear power plant equipment, the system comprising:
an information input unit into which nuclear power plant installation information related to nuclear power plant equipment is input;
a simulation implementation unit configured to generate a virtual reality simulation related to the nuclear power plant equipment on the basis of the nuclear power plant equipment installation information, and allow the virtual reality simulation to be output through a nuclear power plant equipment installation simulation program; and
a utilization unit configured to output the virtual reality simulation.

2. The construction simulation system of claim 1,
wherein the nuclear power plant equipment installation information comprises at least one of a three-dimensional (3D) model, a scenario, general information, an experience image, a video, a checklist, and other information of the nuclear power plant equipment,
wherein the 3D model of the nuclear power plant equipment comprises design information,
wherein the scenario comprises a scenario generated on the basis of experience data and related procedures experienced by an operator in installation of existing nuclear power plant equipment,
wherein the general information comprises reference information having at least one of term definitions and safety guidelines,
wherein the experience image comprises data taken when the operator installed the existing nuclear power plant equipment,
wherein the video comprises a video related to nuclear power plant equipment of a preceding power plant,
wherein the checklist comprises inspection items to inspect at a time of installing the nuclear power plant equipment, and
wherein the other information comprises two-dimensional (2D) drawings.

3. The construction simulation system of claim 1, further comprising:
an information storage unit configured to store the nuclear power plant equipment installation information,
wherein the information storage unit comprises:
a 3D storage unit configured to store 3D model information;
a scenario storage unit configured to store scenario information that refers to installation experience data of the nuclear power plant equipment and the WPP/QCI procedure documents; and
a related information storage unit configured to store at least one of term definitions, general matters, attachments, and corresponding procedures required for construction of the nuclear power plant equipment.

4. The construction simulation system of claim 1, wherein the nuclear power plant installation simulation program comprises:
a first screen for selecting the nuclear power plant equipment to be constructed;
a second screen outputting information on the construction of the nuclear power plant equipment;
a third screen outputting information on construction activity information of the nuclear power plant equipment and allowing an operator to select a simulation; and
a fourth screen outputting a simulation for the construction of the nuclear power plant equipment.

5. The construction simulation system of claim 4, wherein the first screen outputs an image of the nuclear power plant equipment so as to enable selection of the nuclear power plant equipment.

6. The construction simulation system of claim 4, wherein the second screen comprises:
a term definition outputting button for outputting information on term definitions, safety guidelines, and general matters for the nuclear power plant equipment;
a safety guideline outputting button for outputting information to be used in activities of the construction of the nuclear power plant equipment, check items, and caution-required items;
a safety guideline outputting button for outputting information on reference forms and relevant documents related to the construction of the nuclear power plant equipment; and
a drawing outputting button for outputting information on 2D drawings and 3D models related to activities of the construction of the nuclear power plant equipment.

7. The construction simulation system of claim 4, wherein the third screen comprises a construction simulation activity button for selecting a necessary simulation from among a plurality of simulations for the nuclear power plant equipment.

8. The construction simulation system of claim 4, wherein the fourth screen outputs a simulation image for the construction of the nuclear power plant equipment and comprises:
a common information outputting button for outputting the term definitions, safety guidelines, and general matters necessary for the construction of the nuclear power plant equipment;
an information outputting button for outputting basic information, check items, and caution-required items necessary for the construction of the nuclear power plant equipment;
a document outputting button for outputting reference forms and relevant documents necessary for the construction of the nuclear power plant equipment;
a drawing outputting button for outputting drawings necessary for the construction of the nuclear power plant equipment;
an experience image outputting button for outputting a photograph at a time of prior construction of the nuclear power plant equipment; and
an inspection item check button for outputting inspection items related to the construction of the nuclear power plant equipment.

9. The construction simulation system of claim 1, wherein the utilization unit is capable of operating the nuclear power plant installation simulation program.

10. A construction simulation method for nuclear power plant equipment, the method comprising:
entering nuclear power plant equipment installation information related to nuclear power plant equipment;
generating a virtual reality simulation related to the nuclear power plant equipment on the basis of the nuclear power plant equipment installation information and outputting the virtual reality simulation through a nuclear power plant equipment installation simulation program; and
outputting the virtual reality simulation by the utilization unit.
